# EUROPEAN PATENT APPLICATION

(11) **EP 4 700 147 A2**
(43) Date of publication of application: **25.02.2026**
(21) Application number: 25188908.5
(22) Date of filing: 10.07.2025
(51) Int. Cl.: C23C 14/04, H10K 71/16

(54) **DEVICE AND METHOD FOR ASSEMBLING MASK**

(30) Priority: 22.08.2024 KR 20240112863
(71) Applicant: Samsung Display Co., Ltd., Yongin-si, Gyeonggi-do 17113 (KR)
(72) Inventor: OH, Sang Hoon, Yongin-si (KR); KANG, Taek Kyo, Yongin-si (KR); KIM, Do Sun, Yongin-si (KR); KANG, Eu Gene, Yongin-si (KR)
(74) Representative: Marks & Clerk LLP

(57) **Abstract**

A mask assembly device includes a front mask mount and a rear mask mount, where each of the front mask mount and the rear mask mount includes a mask mount stand, and a bridge mount including a bridge mount stand. The bridge mount stand includes a bridge mount stand top positioned between the front mask mount and the rear mask mount, and a bridge mount stand magnet which provides a magnetic flux to the bridge mount stand top.

## Description

### BACKGROUND

### (1) Field

The disclosure relates to a mask assembly device and a method of assembling a mask.

### (2) Description of the Related Art

In a process of manufacturing a display panel, a plurality of mask sticks may be connected to each other. When connecting the mask sticks, the mask sticks may be desired to be precisely arranged.

### SUMMARY

One or more embodiments of the disclosure provide a mask assembly device and a method of assembling a mask by welding and connecting a plurality of mask sticks using a bridge stick.

According to an embodiment of the disclosure, a mask assembly device includes a front mask mount and a rear mask mount, where each of the front mask mount and the rear mask mount includes a mask mount stand; and a bridge mount including a bridge mount stand, where the bridge mount stand includes a bridge mount stand top positioned between the front mask mount and the rear mask mount and a bridge mount stand magnet configured to provide a magnetic flux to the bridge mount stand top.

In some embodiments, an upper surface of the bridge mount may be positioned below an upper surface of the front mask mount and an upper surface of the rear mask mount. The bridge mount stand magnet may be positioned below the bridge mount stand top.

In some embodiments, the bridge mount stand may further include a bridge mount stand body coupled to the bridge mount stand top. The bridge mount stand magnet may be movably coupled to the bridge mount stand body in a way such that the bridge mount stand magnet is configured to be movable toward or away from the bridge mount stand top.

In some embodiments, the bridge mount stand magnet may be configured to form a magnetic field corresponding to a current applied to the bridge mount stand magnet.

In some embodiments, the bridge mount stand may further include a bridge mount base and a bridge mount leg connecting the bridge mount base to the bridge mount stand.

In some embodiments, the bridge mount stand may be coupled to the bridge mount leg in a way such that the bridge mount stand is configured to be movable up and down with respect to the bridge mount base.

In some embodiments, a suction hole may be defined on an upper surface of the bridge mount stand top.

In some embodiments, the mask mount stand may include a mask mount stand body, a mask mount stand top defining an upper surface of a corresponding one of the front mask mount and the rear mask mount. The mask mount stand may include a mask mount stand electrode positioned below the mask mount stand top and positioned in the mask mount stand body.

In some embodiments, the mask mount stand top may include a material including a dielectric.

According to an embodiment of the disclosure, a mask assembly method includes arranging a mask stick on an upper surface of a mask mount stand and arranging a bridge stick on an upper surface of a bridge mount stand, where the mask stick is positioned above the bridge stick; coupling the mask stick to the bridge stick; and welding an area in which the mask stick and the bridge stick overlap each other.

In some embodiments, the coupling the mask stick to the bridge stick may include moving the bridge mount stand up to allow the bridge stick to approach the mask stick, and bringing the bridge stick into close contact with the mask stick.

In some embodiments, the bridge mount stand may include a bridge mount stand body, and a bridge mount stand top connected to the bridge mount stand body. The bridge stick may be seated on an upper surface of the bridge mount stand top. The bridge mount stand may include a bridge mount stand magnet positioned below the bridge mount stand top. The bridge mount stand magnet may be configured to provide a magnetic flux to the bridge mount stand top.

In some embodiments, the bridge mount stand magnet may be movably coupled to at least one selected from the bridge mount stand body and the bridge mount stand top. In such embodiments, when the bridge mount stand magnet approaches the bridge mount stand top, the bridge stick may be in close contact with the mask stick.

In some embodiments, the bridge mount stand magnet may include an electromagnet. In such embodiments, when a magnitude of a current applied to the bridge mount stand magnet increases, the bridge stick may be in close contact with the mask stick.

In some embodiments, the mask assembly method may further include, after the welding, reducing an intensity of the magnetic flux provided by the bridge mount stand magnet to the bridge mount stand top, and moving the bridge mount stand down.

In some embodiments, a suction hole may be defined on the bridge mount stand top, and the arranging the bridge stick on the upper surface of the bridge mount stand and coupling the mask stick to the bridge stick may include adsorbing the bridge stick on the bridge mount stand top through the suction hole.

In some embodiments, the arranging the mask stick on the upper surface of the mask mount stand may include capacitively coupling the mask stick to the mask mount stand.

According to an embodiment of the disclosure, a mask includes a mask stick including a front mask stick extending in a left-right direction and a rear mask stick extending in the left-right direction and disposed behind the front mask stick to be spaced apart from the front mask stick; and a bridge stick connecting the front mask stick to the rear mask stick, where the bridge stick is positioned below the front mask stick and the rear mask stick, the bridge stick extends in the left-right direction, and an upper surface of the bridge stick is in contact with a lower surface of the mask stick and is welded and coupled to the mask stick.

In some embodiments, the mask may further include a weld bead positioned on at least one selected from the mask stick and the bridge stick.

In some embodiments, the weld bead may be positioned in an area of an upper surface of the mask stick, in which the mask stick and the bridge stick overlap each other.

A mask assembly device and method according to one or more embodiments of the disclosure can weld and connect a plurality of mask sticks using a bridge stick.

At least some of the above and other features of the invention are set out in the claims.

### BRIEF DESCRIPTION OF THE DRAWINGS

The above and other features of embodiments of the invention will become more apparent by describing in further detail embodiments thereof with reference to the accompanying drawings, in which:
FIG. 1 illustrates a mask assembly device according to an embodiment of the disclosure;
FIG. 2 illustrates a mask stick according to an embodiment of the disclosure;
FIG. 3 illustrates a bridge stick according to an embodiment of the disclosure;
FIG. 4 illustrates a mask stick illustrated in FIG. 2 and a bridge stick illustrated in FIG. 3 that are seated on a mask assembly device illustrated in FIG. 1;
FIG. 5 illustrates a cross section of a mask assembly device, a mask stick, and a bridge stick illustrated in FIG. 4 taken along A1-A2 of FIG. 4;
FIG. 6 illustrates a bridge mount illustrated in FIG. 5;
FIG. 7 illustrates a bridge mount stand illustrated in FIG. 5 that moves up;
FIG. 8 illustrates a part of FIG. 7 in which a mask stick and a bridge stick are welded in a state of being fixed to a bridge mount;
FIG. 9 illustrates in detail a mask mount stand illustrated in FIG. 5;
FIG. 10 is a block diagram of a mask assembly device according to an embodiment of the disclosure;
FIG. 11 illustrates a part of FIG. 7 in which a bridge mount is positioned above a mask mount, and a mask stick and a bridge stick are welded in a state of being fixed to the bridge mount;
FIG. 12 is a flowchart illustrating a mask assembly method according to an embodiment of the disclosure;
FIG. 13 is a flowchart illustrating a stick arrangement process;
FIG. 14 is a flowchart illustrating a stick coupling process; and
FIG. 15 is a flowchart illustrating a stick detachment process.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

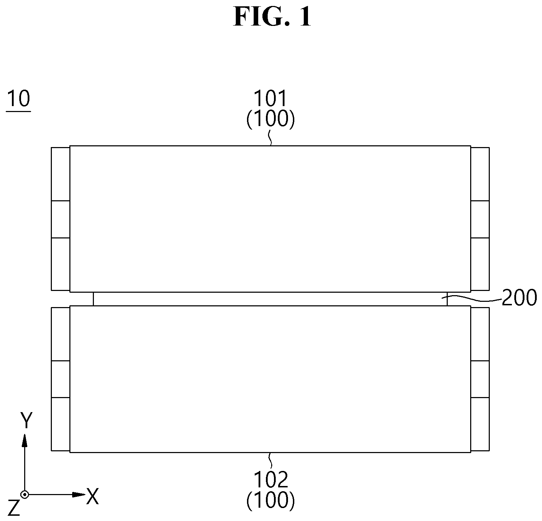

FIG. 1 illustrates a mask assembly device according to an embodiment of the disclosure.

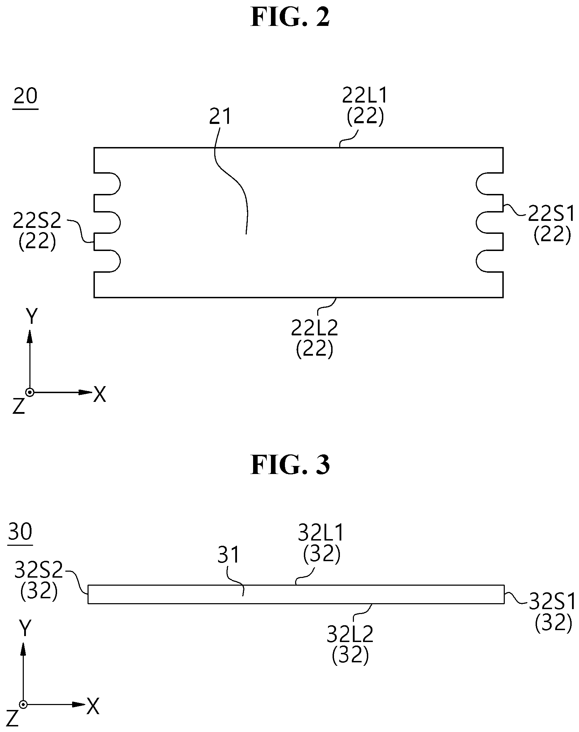

An embodiment of a mask assembly device 10 may sequentially connect a plurality of mask sticks 20 (see FIG. 2) to each other. In an embodiment, for example, the mask assembly device 10 may be configured in a way such that a bridge stick 30 (see FIG. 3) overlaps between two mask sticks 20 (see FIG. 2) and is coupled thereto.

The mask assembly device 10 may include a mask mount 100. In an embodiment, the mask mount 100 may be provided in plural, that is, a plurality of mask mounts 100 may be provided. In such an embodiment, the mask assembly device 10 may include the plurality of mask mounts 100.

In an embodiment, for example, the mask assembly device 10 may include a first mask mount 101 and a second mask mount 102. The mask mount 100 may include or indicate at least one selected from the first mask mount 101 and the second mask mount 102.

In an embodiment, for example, the first mask mount 101 and the second mask mount 102 may be spaced apart from each other. In an embodiment, for example, a gap may be formed between the first mask mount 101 and the second mask mount 102.

The first mask mount 101 and the second mask mount 102 may be disposed side by side. In an embodiment, for example, the first mask mount 101 may be positioned in front of the second mask mount 102.

In this context, the first mask mount 101 may be referred to as a "front mask mount" and the second mask mount 102 may be referred to as a "rear mask mount".

In an embodiment, for example, the first mask mount 101 and the second mask mount 102 may be disposed in a Y-axis direction. A positive Y-axis direction may indicate the forward. A negative Y-axis direction may indicate the rearward.

The X-axis and the Y-axis may form a horizontal plane. For example, the positive X-axis direction may indicate a right direction. For example, the negative X-axis direction may indicate a left direction.

The Z-axis may be perpendicular to the horizontal plane. For example, the positive Z-axis direction may indicate the upward. For example, the negative Z-axis direction may indicate the downward.

The mask stick 20 (see FIG. 2) may be mounted or disposed on the mask mount 100. In an embodiment, for example, the mask stick 20 (see FIG. 2) may be positioned on an upper surface of the mask mount 100.

The mask assembly device 10 may include a bridge mount 200. The bridge mount 200 may be adjacent to the mask mount 100. In an embodiment, for example, the bridge mount 200 may be positioned between the first mask mount 101 and the second mask mount 102.

In an embodiment, for example, the bridge mount 200 may be positioned behind the first mask mount 101. In an embodiment, for example, the bridge mount 200 may be positioned in front of the second mask mount 102. That is, the first mask mount, 101, the bridge mount 200 and the second mask mount 102 may be sequentially arranged in the negative Y-axis direction.

The bridge stick 30 (see FIG. 3) may be mounted or disposed on the bridge mount 200. In an embodiment, for example, the bridge stick 30 (see FIG. 3) may be positioned on an upper surface of the bridge mount 200.

A direction in which the first mask mount 101 and the second mask mount 102 are disposed may be a width direction of the mask mount 100. A longitudinal direction of the mask mount 100 may intersect or be orthogonal to the width direction.

For example, the longitudinal direction of the mask mount 100 may be a left-right direction. For example, the longitudinal direction of the mask mount 100 may be the X-axis. For example, the width direction of the mask mount 100 may be a front-rear direction. For example, the width direction of the mask mount 100 may be the Y-axis.

FIG. 2 illustrates a mask stick according to an embodiment of the disclosure.

Referring to FIG. 2, an embodiment of the mask stick 20 may include a mask stick body 21. The mask stick body 21 may have a plate shape or a board shape.

In an embodiment, for example, the mask stick body 21 may have an upper surface and a lower surface. For example, an upper surface of the mask stick 20 may be the surface shown in FIG. 2. The upper surface of the mask stick body 21 may be directed toward or face the upward or the positive Z-axis direction.

The lower surface of the mask stick body 21 may be directed toward or face the downward or the negative Z-axis direction. In an embodiment, for example, in a state in which the mask stick 20 is positioned on the mask mount 100 (see FIG. 1), the lower surface of the mask stick body 21 may face the upper surface of the mask mount 100 (see FIG. 1) or may be in contact with the upper surface of the mask mount 100 (see FIG. 1).

The mask stick 20 may include a mask stick edge 22. The mask stick edge 22 may be an edge formed on the mask stick body 21. The mask stick edge 22 may form a perimeter of the mask stick 20.

The mask stick edge 22 may be divided into a plurality of portions. In an embodiment, for example, the mask stick edge 22 may include or indicate at least one selected from a first mask stick long edge 22L1, a first mask stick short edge 22S1, a second mask stick long edge 22L2, or a second mask stick short edge 22S2.

The first mask stick long edge 22L1, the first mask stick short edge 22S1, the second mask stick long edge 22L2, and the second mask stick short edge 22S2 may be sequentially connected to each other in a plan view or when viewed in the Z-axis direction or a thickness direction of the mask stick body 21.

The mask stick 20 may have an extended or elongated shape in one direction. In an embodiment, for example, the mask stick 20 may extend in a longitudinal direction from the first mask stick short edge 22S1 and lead to the second mask stick short edge 22S2.

In an embodiment, for example, the longitudinal direction of the mask stick 20 may be a direction in which the mask stick 20 extends. The longitudinal direction of the mask stick 20 may be the longitudinal direction of the mask mount 100 or the X-axis direction (see FIG. 1). A width direction of the mask stick 20 may be the width direction of the mask mount 100 or the Y-axis direction (see FIG. 1).

In an embodiment, for example, a distance between the first mask stick long edge 22L1 and the second mask stick long edge 22L2 may be a width of the mask stick 20. In an embodiment, for example, a distance between the first mask stick short edge 22S1 and the second mask stick short edge 22S2 may be a length of the mask stick 20 (based on the longitudinal direction).

The first mask stick long edge 22L1 may extend in the longitudinal direction from a front end of the first mask stick short edge 22S1 and lead to a front end of the second mask stick short edge 22S2. In this context, the first mask stick long edge 22L1 may be referred to as a "mask stick front edge".

The second mask stick long edge 22L2 may extend in the longitudinal direction from a rear end of the first mask stick short edge 22S1 and lead to a rear end of the second mask stick short edge 22S2. In this context, the second mask stick long edge 22L2 may be referred to as a "mask stick rear edge".

FIG. 3 illustrates a bridge stick according to an embodiment of the disclosure.

Referring to FIG. 3, an embodiment of the bridge stick 30 may include a bridge stick body 31. The bridge stick body 31 may have a plate shape or a board shape.

In an embodiment, for example, the bridge stick body 31 may have an upper surface and a lower surface. In an embodiment, for example, the upper surface of the bridge stick 30 may be the surface shown in FIG. 3. The upper surface of the bridge stick body 31 may be directed toward or face the upward or the positive Z-axis direction.

The lower surface of the bridge stick body 31 may be directed toward or face the downward or the negative Z-axis direction. In an embodiment, for example, in a state in which the bridge stick 30 is positioned on the bridge mount 200 (see FIG. 1), the lower surface of the bridge stick body 31 may face the upper surface of the bridge mount 200 (see FIG. 1) or may be in contact with the upper surface of the bridge mount 200 (see FIG. 1).

The bridge stick 30 may include a bridge stick edge 32. The bridge stick edge 32 may include or indicate at least one selected from a first bridge stick long edge 32L1, a first bridge stick short edge 32S1, a second bridge stick long edge 32L2, or a second bridge stick short edge 32S2.

The first bridge stick long edge 32L1, the first bridge stick short edge 32S1, the second bridge stick long edge 32L2, and the second bridge stick short edge 32S2 may be sequentially connected to each other in a plan view or when viewed in the Z-axis direction.

The bridge stick 30 may have an extended or elongated shape in one direction. In an embodiment, for example, the bridge stick 30 may extend in a longitudinal direction from the first bridge stick short edge 32S1 and lead to the second bridge stick short edge 32S2.

In an embodiment, for example, the longitudinal direction of the bridge stick 30 may be a direction in which the bridge stick 30 extends. The longitudinal direction of the bridge stick 30 may be a longitudinal direction of the bridge mount 200 or in the positive X-axis direction (see FIG. 1). The longitudinal direction of the bridge mount 200 (see FIG. 1) may be the longitudinal direction of the mask mount 100 or in the positive X-axis direction (see FIG. 1).

A width direction of the bridge stick 30 may be a width direction of the bridge mount 200 (see FIG. 1). The width direction of the bridge mount 200 (see FIG. 1) may be the width direction of the mask mount 100 (see FIG. 1).

In an embodiment, for example, a distance between the first bridge stick long edge 32L1 and the second bridge stick long edge 32L2 may be a width of the bridge stick 30. In an embodiment, for example, a distance between the first bridge stick short edge 32S1 and the second bridge stick short edge 32S2 may be a length of the bridge stick 30 (based on the longitudinal direction).

The first bridge stick long edge 32L1 may extend in the longitudinal direction from a front end of the first bridge stick short edge 32S1 and lead to a front end of the second bridge stick short edge 32S2. In this context, the first bridge stick long edge 32L1 may be referred to as a "bridge stick front edge".

The second bridge stick long edge 32L2 may extend in the longitudinal direction from a rear end of the first bridge stick short edge 32S1 and lead to a rear end of the second bridge stick short edge 32S2. In this context, the second bridge stick long edge 32L2 may be referred to as a "bridge stick rear edge".

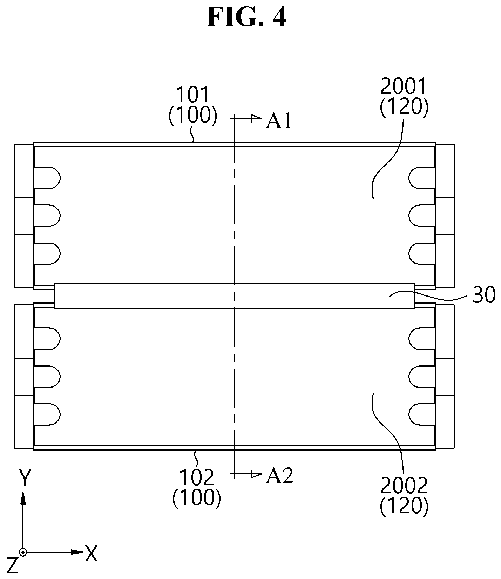

FIG. 4 illustrates a mask stick illustrated in FIG. 2 and a bridge stick illustrated in FIG. 3 that are seated on a mask assembly device illustrated in FIG. 1.

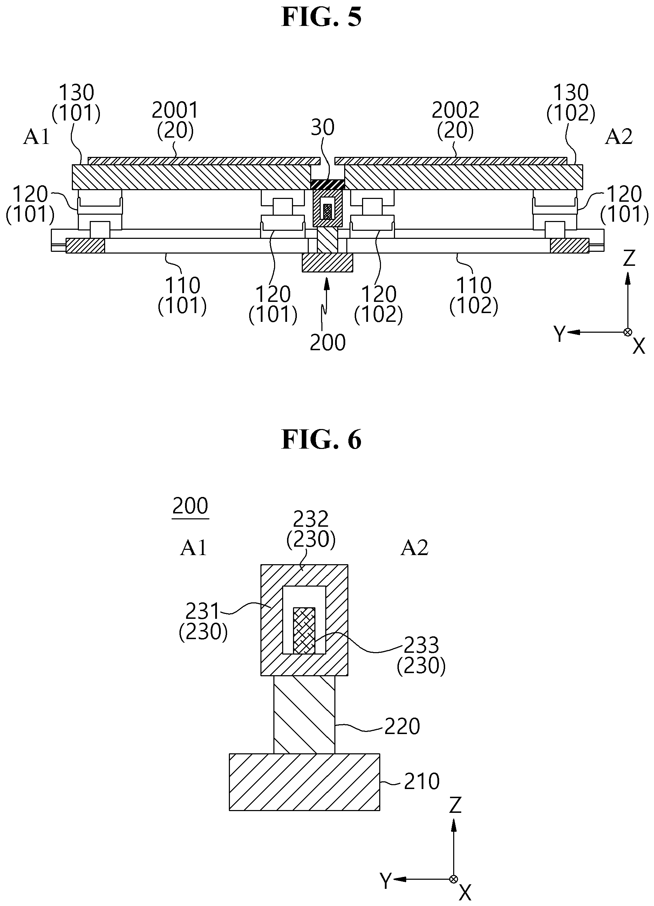

FIG. 5 illustrates a cross section of a mask assembly device, a mask stick, and a bridge stick illustrated in FIG. 4 taken along A1-A2 of FIG. 4.

FIG. 6 illustrates a bridge mount illustrated in FIG. 5.

Referring to FIGS. 4 to 6, an embodiment of the mask mount 100 may include a mask mount base 110. The mask mount base 110 may define a lower portion of the mask mount 100.

The mask mount 100 may include a mask mount stand 130. The mask mount stand 130 may define an upper portion of the mask mount 100.

In an embodiment, for example, the mask mount stand 130 may define the upper surface of the mask mount 100. In an embodiment, for example, the mask stick 20 may be seated on an upper surface of the mask mount stand 130.

The mask mount 100 may include at least one mask mount leg 120. The mask mount leg 120 may be connected or coupled to the mask mount base 110. In an embodiment, for example, a lower end of the mask mount leg 120 may be connected or coupled to the mask mount base 110.

The mask mount leg 120 may be connected or coupled to the mask mount stand 130. In an embodiment, for example, an upper end of the mask mount leg 120 may be connected or coupled to the mask mount stand 130.

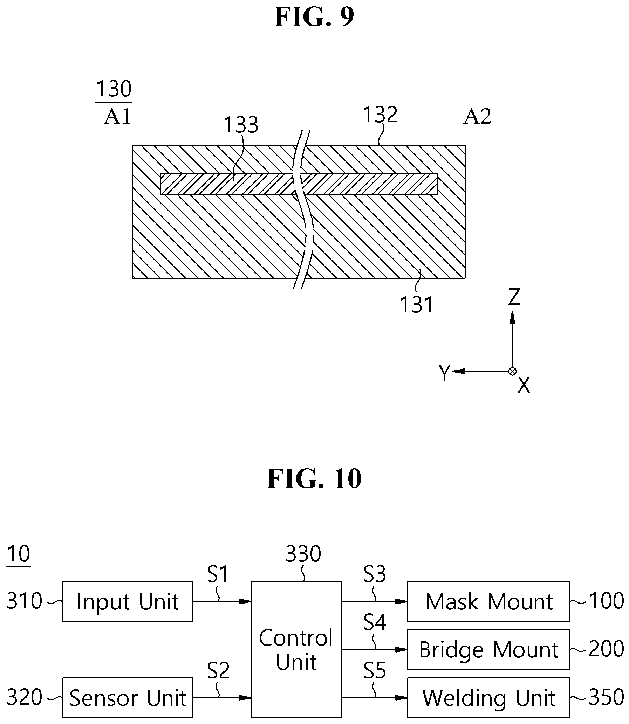

At least one selected from a position and a shape of the mask mount leg 120 may be controlled. In an embodiment, for example, a control unit 330 (see FIG. 10) may control at least one selected from the position and the shape of the mask mount leg 120.

When at least one selected from the position and the shape of the mask mount leg 120 is controlled, at least one selected from a position and a posture of the mask mount stand 130 may be controlled.

When at least one selected from the position and the posture of the mask mount stand 130 is controlled, at least one selected from a position and a posture of the mask stick 20 mounted on the mask mount 100 may be controlled. That is, the mask mount leg 120 may adjust at least one selected from the position and the posture of the mask stick 20 mounted on the mask mount 100.

The mask mount stand 130 may be movably coupled to the mask mount base 110. In an embodiment, for example, the mask mount stand 130 may be movably coupled to the mask mount base 110 through the mask mount leg 120.

The plurality of mask sticks 20 may be seated on the mask mount 100. The mask stick 20 may include or indicate at least one selected from a first mask stick 2001 and a second mask stick 2002.

In an embodiment, for example, the first mask stick 2001 may be seated on the first mask mount 101, and the second mask stick 2002 may be seated on the second mask mount 102.

The first mask stick 2001 and the second mask stick 2002 may be spaced apart from each other in a state in which they are seated on the mask mount 100. In an embodiment, for example, the first mask stick 2001 may be positioned in front of the second mask stick 2002.

The bridge mount 200 may include a bridge mount base 210. The bridge mount base 210 may define a lower portion of the bridge mount 200.

The bridge mount 200 may include a bridge mount stand 230. The bridge mount stand 230 may define an upper portion of the bridge mount 200.

In an embodiment, for example, the bridge mount stand 230 may define an upper surface of the bridge mount 200. In an embodiment, for example, the bridge stick 30 may be seated on an upper surface of the bridge mount stand 230.

The bridge mount 200 may include a bridge mount leg 220. The bridge mount leg 220 may be connected or coupled to the bridge mount base 210. In an embodiment, for example, a lower end of the bridge mount leg 220 may be connected or coupled to the bridge mount base 210. In an embodiment, for example, the bridge mount leg 220 may form a shape extending upward from the bridge mount base 210.

In an embodiment, for example, the lower end of the bridge mount leg 220 may be accommodated or connected to the bridge mount base 210. In an embodiment, for example, the bridge mount leg 220 may be coupled to the bridge mount base 210 to enable the up-down movement thereof, that is, to allow the bridge mount base 210 to move the upward and downward directions. In an embodiment, for example, the bridge mount leg 220 and the bridge mount base 210 may be coupled in a pinion-rack structure.

The bridge mount leg 220 may be connected or coupled to the bridge mount stand 230. In an embodiment, for example, an upper end of the bridge mount leg 220 may be connected or coupled to the bridge mount stand 230. In an embodiment, for example, the bridge mount stand 230 may form a shape extending upward from the bridge mount leg 220.

At least one selected from a position and a shape of the bridge mount leg 220 may be adjusted. In an embodiment, for example, the upper end of the bridge mount leg 220 may move up or down with respect to the bridge mount base 210. In an embodiment, for example, the control unit 330 (see FIG. 10) may control at least one selected from the position and the shape of the bridge mount leg 220.

When at least one selected from the position and the shape of the bridge mount leg 220 is controlled, at least one selected from a position and a posture of the bridge mount stand 230 may be controlled.

When at least one selected from the position and the posture of the bridge mount stand 230 is controlled, at least one selected from a position and a posture of the bridge stick 30 mounted on the bridge mount 200 may be controlled. That is, the bridge mount leg 220 may adjust at least one selected from the position and the posture of the bridge stick 30 mounted on the bridge mount 200.

The bridge mount 200 may be positioned between the first mask mount 101 and the second mask mount 102. In an embodiment, for example, the bridge mount stand 230 may be positioned between a mask mount stand 130 of the first mask mount 101 and a mask mount stand 130 of the second mask mount 102.

The upper surface of the bridge mount stand 230 may be positioned below the upper surface of the mask mount stand 130. The bridge stick 30 may be positioned below the mask stick 20.

In an embodiment, for example, the upper surface of the bridge mount stand 230 may be positioned below an upper surface of the mask mount stand 130 of the first mask mount 101.

In an embodiment, for example, the bridge stick 30 may be positioned below the front mask stick 2001. In an embodiment, for example, the bridge stick 30 may be positioned below the mask stick rear edge 22L2 (see FIG. 2) of the front mask stick 2001. In an embodiment, for example, the front mask stick 2001 may be positioned on the bridge stick front edge 32L1 (see FIG. 3) of the bridge stick 30.

In an embodiment, for example, the upper surface of the bridge mount stand 230 may be positioned below an upper surface of the mask mount stand 130 of the second mask mount 102.

In an embodiment, for example, the bridge stick 30 may be positioned below the rear mask stick 2002. In an embodiment, for example, the bridge stick 30 may be positioned below the mask stick front edge 22L1 (see FIG. 2) of the rear mask stick 2002. In an embodiment, for example, the rear mask stick 2002 may be positioned on the bridge stick rear edge 32L2 (see FIG. 3) of the bridge stick 30.

The bridge mount stand 230 may include a bridge mount stand body 231. The bridge mount stand body 231 may be connected or coupled to the bridge mount leg 220.

In an embodiment, for example, the bridge mount stand 230 may be connected or coupled to the upper end of the bridge mount leg 220. In an embodiment, for example, the bridge mount stand 230 may form a shape extending upward from the bridge mount leg 220.

The bridge mount stand 230 may include a bridge mount stand top 232. The bridge mount stand top 232 may define the upper surface of the bridge mount stand 230.

In an embodiment, for example, the bridge stick 30 may be seated on an upper surface of the bridge mount stand top 232. In an embodiment, for example, the bridge stick 30 may be coupled to the upper surface of the bridge mount stand top 232.

The bridge mount stand top 232 may be connected or coupled to the bridge mount stand body 231. In an embodiment, for example, the bridge mount stand top 232 may extend from the bridge mount stand body 231. In an embodiment, for example, the bridge mount stand top 232 may be integrally formed with the bridge mount stand body 231 as a single unitary indivisible part.

The bridge mount stand 230 may include a bridge mount stand magnet 233. The bridge mount stand magnet 233 may be connected to, coupled to, or accommodated in at least one selected from the bridge mount stand body 231 and the bridge mount stand top 232.

In an embodiment, for example, the bridge mount stand magnet 233 may be movably coupled to at least one selected from the bridge mount stand body 231 and the bridge mount stand top 232.

In an embodiment, for example, the bridge mount stand magnet 233 may be movably coupled to the bridge mount stand body 231. In an embodiment, for example, the bridge mount stand magnet 233 may be positioned below the bridge mount stand top 232.

The bridge mount stand magnet 233 may form a magnetic field. In an embodiment, the bridge mount stand magnet 233 may include, for example, a permanent magnet. In another embodiment, for example, the bridge mount stand magnet 233 may include an electromagnet.

At least one suction hole (not shown) may be defined or formed on an upper surface of the bridge mount stand top 232. In an embodiment, the suction hole (not shown) formed on the upper surface of the bridge mount stand top 232 may suck air.

When the suction hole (not shown) formed on the upper surface of the bridge mount stand top 232 sucks air, the bridge stick 30 may be in contact with or coupled to the bridge mount stand top 232. A coupling force between the bridge stick 30 and the bridge mount stand top 232 may be variously set depending on a suction force of the suction hole (not shown).

The bridge mount stand 230 may be movably coupled to the bridge mount base 210. In an embodiment, for example, the bridge mount stand 230 may be coupled to the bridge mount base 210 through the bridge mount leg 220 to enable the up-down movement thereof.

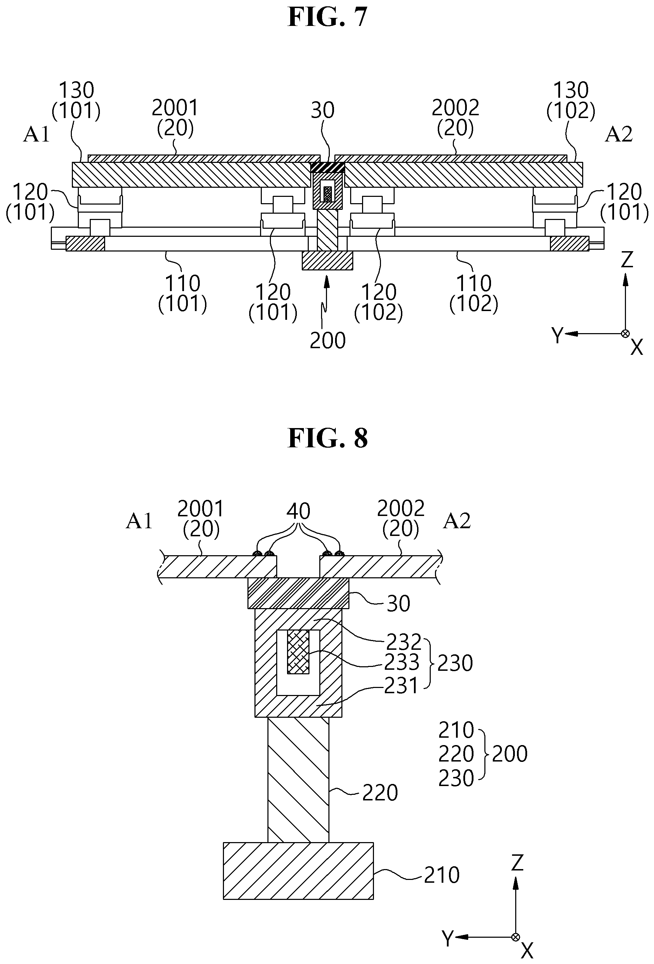

FIG. 7 illustrates a bridge mount stand illustrated in FIG. 5 that moves up.

Referring to FIGS. 6 and 7, the bridge mount stand 230 may move up. In an embodiment, for example, the bridge mount stand 230 may move up with respect to the bridge mount base 210.

In an embodiment, for example, the upper end of the bridge mount leg 220 may move up with respect to the bridge mount base 210. In an embodiment, for example, the upper end of the bridge mount leg 220 may move up with respect to the lower end of the bridge mount leg 220.

When the bridge mount stand 230 moves up, the bridge stick 30 may approach the mask stick 20. In an embodiment, for example, when the bridge mount stand 230 move up, the bridge stick 30 may be in contact with the mask stick 20.

The bridge mount stand magnet 233 may provide a magnetic flux to the bridge mount stand top 232. At least a portion of the magnetic flux provided to the bridge mount stand top 232 may be incident on the bridge stick 30.

The magnetic flux provided to the bridge mount stand top 232 may be variously set. In an embodiment, for example, a distance between the bridge mount stand magnet 233 and the bridge mount stand top 232 may be adjusted.

In an embodiment, for example, when the bridge mount stand magnet 233 approaches or moves toward the bridge mount stand top 232 in a state where the bridge mount stand magnet 233 forms the magnetic field, a magnitude or an intensity of the magnetic flux provided to the bridge mount stand top 232 may increase.

In an embodiment, for example, when the bridge mount stand magnet 233 moves away from the bridge mount stand top 232 in a state where the bridge mount stand magnet 233 forms the magnetic field, the magnitude or the intensity of the magnetic flux provided to the bridge mount stand top 232 may decrease.

In an embodiment, for example, where the bridge mount stand magnet 233 includes the electromagnet, the power applied to the bridge mount stand top 232 may be controlled.

In an embodiment, for example, where the bridge mount stand magnet 233 is the electromagnet, if a current applied to the bridge mount stand magnet 233 increases, the magnitude or the intensity of the magnetic flux provided to the bridge mount stand top 232 may increase.

In an embodiment, for example, where the bridge mount stand magnet 233 is the electromagnet, if a current applied to the bridge mount stand magnet 233 decreases, the magnitude or the intensity of the magnetic flux provided to the bridge mount stand top 232 may decrease.

The mask stick 20 and the bridge stick 30 may include or be formed of a material including a metal. In an embodiment, for example, the mask stick 20 and the bridge stick 30 may include or be formed of a material including a ferromagnetic material. In an embodiment, for example, the mask stick 20 and the bridge stick 30 may include or be formed of a material including iron. In an embodiment, for example, the mask stick 20 and the bridge stick 30 may include or be formed of a material including a paramagnetic material.

A portion of the magnetic flux formed by the bridge mount stand magnet 233 may be transferred to the mask stick 20 and the bridge stick 30. The magnetic flux transferred to the mask stick 20 may induce a magnetic field in the mask stick 20. The magnetic flux transferred to the bridge stick 30 may induce a magnetic field in the bridge stick 30.

The mask stick 20 and the bridge mount stand magnet 233 may be magnetically coupled to each other. The bridge stick 30 and the bridge mount stand magnet 233 may be magnetically coupled to each other. The bridge stick 30 and the mask stick 20 may be magnetically coupled to each other.

That is, the bridge stick 30 and the mask stick 20 may be coupled to the bridge mount stand top 232. The degree to which the bridge stick 30 and the mask stick 20 are coupled to the bridge mount stand top 232 may depend on the intensity of the magnetic flux applied to the bridge stick 30 and the mask stick 20.

In an embodiment, for example, when the intensity of the magnetic flux applied to the bridge stick 30 and the mask stick 20 increases, the degree to which the bridge stick 30 and the mask stick 20 are coupled to the bridge mount stand top 232 may increase.

In an embodiment, for example, when the intensity of the magnetic flux applied to the bridge stick 30 and the mask stick 20 decreases, the degree to which the bridge stick 30 and the mask stick 20 are coupled to the bridge mount stand top 232 may decrease.

In an embodiment, for example, the intensity of the magnetic flux applied to the bridge stick 30 and the mask stick 20 may be variously set depending on the distance between the bridge mount stand top 232 and the bridge mount stand magnet 233.

In an embodiment, for example, the intensity of the magnetic flux applied to the bridge stick 30 and the mask stick 20 may be variously set depending on a magnetic force of the bridge mount stand magnet 233. The magnetic force of the bridge mount stand magnet 233 may be variously set depending on a magnitude of the current applied to the bridge mount stand magnet 233 in an embodiment where the bridge mount stand magnet 233 includes the electromagnet.

FIG. 8 illustrates a part of FIG. 7 in which a mask stick and a bridge stick are welded in a state of being fixed to a bridge mount. Referring to FIGS. 7 and 8, the intensity of the magnetic flux applied to the bridge stick 30 and the mask stick 20 may increase.

In an embodiment, for example, the bridge mount stand magnet 233 may move up. In an embodiment, for example, the bridge mount stand magnet 233 may approach the bridge mount stand top 232.

In an embodiment, for example, where the bridge mount stand magnet 233 includes the electromagnet, the magnitude of the current applied to the bridge mount stand magnet 233 may increase.

When the intensity of the magnetic flux applied to the bridge stick 30 and the mask stick 20 increases, a coupling force between the bridge stick 30 and the mask stick 20 may increase. That is, the bridge stick 30 and the mask stick 20 may be fixed to the bridge mount 200 by the magnetic force of the bridge mount stand magnet 233. In an embodiment, for example, the bridge stick 30 and the mask stick 20 may be in close contact with each other by the magnetic force of the bridge mount stand magnet 233.

In a state where the bridge stick 30 and the mask stick 20 are fixed to the bridge mount 200, a welding unit 350 (see FIG. 10) may weld the mask stick 20 to the bridge stick 30.

In an embodiment, for example, in a state where the bridge stick 30 and the mask stick 20 are fixed to the bridge mount 200, weld beads 40 may be formed in at least one selected from the mask stick 20 and the bridge stick 30. In an embodiment, for example, the weld beads 40 may be formed at a boundary between the mask stick 20 and the bridge stick 30.

In an embodiment, for example, in a state where the bridge stick 30 and the mask stick 20 are fixed to the bridge mount 200, the welding unit 350 (see FIG. 10) may form the weld beads 40 on the upper surface of the mask stick 20.

In an embodiment, for example, the welding unit 350 (see FIG. 10) may apply at least one selected from heat and pressure to the mask stick 20 and the bridge stick 30. In an embodiment, for example, the welding unit 350 (see FIG. 10) may apply the heat and pressure to the mask stick 20 and the bridge stick 30.

In an embodiment, for example, the welding unit 350 (see FIG. 10) may couple the bridge stick 30 to the mask stick 20 in a solid phase welding method. In an embodiment, for example, the welding unit 350 (see FIG. 10) may apply an electron beam to the mask stick 20. In an embodiment, for example, the welding unit 350 (see FIG. 10) may couple the mask stick 20 to the bridge stick 30 in an arc discharge method.

In an embodiment, for example, the welding unit 350 (see FIG. 10) may form the weld beads 40 on the upper surface of the mask stick 20 in a laser welding method. In an embodiment, for example, the welding unit 350 (see FIG. 10) may radiate a laser beam to the upper surface of the mask stick 20.

In an embodiment, for example, the laser beam may be radiated to an area of the boundary between the mask stick 20 and the bridge stick 30 in the upper surface of the mask stick 20.

In an embodiment, for example, the mask stick rear edge 22L2 (see FIG. 2) of the front mask stick 2001 and the bridge stick front edge 32L1 (see FIG. 3) of the bridge stick 30 may form a boundary between the front mask stick 2001 and the bridge stick 30.

In an embodiment, for example, the mask stick front edge 22L1 (see FIG. 2) of the rear mask stick 2002 and the bridge stick rear edge 32L2 (see FIG. 3) of the bridge stick 30 may form a boundary between the rear mask stick 2002 and the bridge stick 30.

The laser beam radiated to the upper surface of the mask stick 20 may transfer heat to the mask stick 20 and the bridge stick 30. A portion of the mask stick 20 and a portion of the bridge stick 30 may be coupled to each other by being melted by heat and then hardened.

A thickness of the mask stick 20 may be different from a thickness of the bridge stick 30. In an embodiment, for example, the thickness of the bridge stick 30 may be greater than the thickness of the mask stick 20. In an embodiment, for example, the thickness of the bridge stick 30 may be two or more times the thickness of the mask stick 20.

FIG. 9 illustrates in detail a mask mount stand illustrated in FIG. 5.

Referring to FIG. 9, an embodiment of the mask mount stand 130 may include a mask mount stand body 131. The mask mount stand body 131 may be coupled or connected to the mask mount leg 120 (see FIG. 5).

The mask mount stand 130 may include a mask mount stand top 132. The mask mount stand top 132 may form the upper surface of the mask mount stand 130.

The mask mount stand top 132 may include or be formed of a material including a nonmagnetic material. In an embodiment, for example, a relative magnetic permeability of the mask mount stand top 132 may be about 1.

The mask mount stand 130 may include a mask mount stand electrode 133. The mask mount stand electrode 133 may include or be formed of an electrically conductive material.

At least a portion of the mask mount stand body 131 may include or be formed of a dielectric material. In an embodiment, for example, at least a portion of the mask mount stand body 131 may be in contact with the mask mount stand electrode 133 and may include or be formed of a dielectric material.

An electric potential may be applied to the mask mount stand electrode 133. In an embodiment, for example, the electric potential of the mask mount stand electrode 133 may be different from an electric potential of the mask stick 20 (see FIG. 5).

In an embodiment, for example, the mask mount stand electrode 133 and the mask stick 20 (see FIG. 5) may be connected to an electric power source. In an embodiment, for example, the mask mount stand electrode 133 and the mask stick 20 (see FIG. 5) may be connected to a direct-current (DC) voltage source.

The mask mount stand electrode 133 and the mask stick 20 (see FIG. 5) may include more different electric charges. In an embodiment, for example, the mask mount stand electrode 133 may include more positive electric charges, and the mask stick 20 (see FIG. 5) may include more negative electric charges. In an embodiment, for example, the mask mount stand electrode 133 may include more negative electric charges, and the mask stick 20 (see FIG. 5) may include more positive electric charges.

The mask mount stand top 132 may be positioned between the mask mount stand electrode 133 and the mask stick 20 (see FIG. 5). A Coulomb force (or electrostatic force) may act between the mask mount stand electrode 133 and the mask stick 20 (see FIG. 5). In other words, the mask mount stand electrode 133 and the mask stick 20 (see FIG. 5) may be capacitively coupled to each other.

In an embodiment, for example, an attractive force may act between the mask mount stand electrode 133 and the mask stick 20 (see FIG. 5). Hence, the mask stick 20 (see FIG. 5) may be in close contact with the mask mount stand top 132.

A coupling force between the mask stick 20 (see FIG. 5) and the mask mount stand top 132 may depend on a difference between the electric potential of the mask mount stand electrode 133 and the electric potential of the mask stick 20 (see FIG. 5).

In an embodiment, for example, as the electric potential difference between the mask mount stand electrode 133 and the mask stick 20 (see FIG. 5) increases, the coupling force between the mask stick 20 (see FIG. 5) and the mask mount stand top 132 may increase.

After the welding of the mask stick 20 and the bridge stick 30 is completed, the mask stick 20 may be separated from the mask mount 100 (see FIG. 5), and the bridge stick 30 (see FIG. 5) may be separated from the bridge mount 200 (see FIG. 5).

Referring to FIGS. 1 to 9, after the welding of the mask stick 20 and the bridge stick 30 is completed, the intensity of the magnetic flux applied to the bridge stick 30 may be weakened or decreased.

In an embodiment, for example, after the welding of the mask stick 20 and the bridge stick 30 is completed, the bridge mount stand magnet 233 may move away from the bridge mount stand top 232. In an embodiment, for example, the bridge mount stand magnet 233 may move down.

In an embodiment, for example, where the bridge mount stand magnet 233 includes an electromagnet, after the welding of the mask stick 20 and the bridge stick 30 is completed, a magnitude of current applied to the bridge mount stand magnet 233 may be reduced.

After the welding of the mask stick 20 and the bridge stick 30 is completed, a coupling force between the mask mount 100 and the mask stick 20 may be weakened. In an embodiment, for example, a reverse electric potential may be applied to the mask mount stand electrode 133 and the mask stick 20. The "reverse electric potential" may indicate an electric potential opposite to the distribution of electric charges respectively formed on the mask mount stand electrode 133 and the mask stick 20.

FIG. 10 is a block diagram of a mask assembly device according to an embodiment of the disclosure.

Referring to FIGS. 1 to 10, an embodiment of the mask assembly device 10 may include an input unit 310. The input unit 310 may obtain an input from a user, etc.

The input unit 310 may generate a first signal S1. The first signal S1 may include information on the input obtained by the input unit 310. In an embodiment, for example, the first signal S1 may include information on at least one selected from operation instructions of the mask mount 100, operation instructions of the bridge mount 200, and operation instructions of the welding unit 350.

The mask assembly device 10 may include a sensor unit 320. The sensor unit 320 may include, for example, a vision sensor. In an embodiment, for example, the sensor unit 320 may detect at least one selected from a position and a posture of the mask mount stand 130. In an embodiment, for example, the sensor unit 320 may detect at least one selected from a position and a posture of the bridge mount stand 230.

In an embodiment, for example, the sensor unit 320 may detect at least one selected from a position and a posture of the mask stick 20 with respect to the mask mount base 110. In an embodiment, for example, the sensor unit 320 may detect at least one selected from a position and a posture of the bridge stick 30 with respect to the bridge mount base 210.

In an embodiment, for example, the sensor unit 320 may detect at least one selected from a position and an intensity of a magnetic field of the bridge mount stand magnet 233. In an embodiment, for example, the sensor unit 320 may detect an intensity of current applied to the bridge mount stand magnet 233. In an embodiment, for example, the sensor unit 320 may detect a magnitude of an electric potential applied to the mask mount stand electrode 133 and the mask stick 20.

The sensor unit 320 may generate a second signal S2. The second signal S2 may include information on a physical quantity detected by the sensor unit 320.

The mask assembly device 10 may include the control unit 330. The control unit 330 may be implemented through at least one selected from a computer, a processor, a server, or a circuit board.

The control unit 330 may perform operations. In an embodiment, for example, the control unit 330 may process signals. In an embodiment, for example, the control unit 330 may generate output signals S3, S4 and S5 based on the input signals S1 and S2.

The input signals S1 and S2 may include at least one selected from the first signal S1 and the second signal S2. The output signals S3, S4 and S5 may include at least one selected from a third signal S3, a fourth signal S4, or a fifth signal S5.

The control unit 330 may transmit the third signal S3 to the mask mount 100. The third signal S3 may include instruction information on the operation of the mask mount 100. The mask mount 100 may operate in response to the third signal S3.

In an embodiment, for example, the mask mount leg 120 may operate in response to the third signal S3, and thus the position and the posture of the mask mount stand 130 may be adjusted. In an embodiment, for example, an electric potential may be formed in the mask mount stand electrode 133 in response to the third signal S3.

The control unit 330 may transmit the fourth signal S4 to the bridge mount 200. The fourth signal S4 may include instruction information on the operation of the bridge mount 200. The bridge mount 200 may operate in response to the fourth signal S4.

In an embodiment, for example, the bridge mount leg 220 may operate in response to the fourth signal S4, and thus the position and the posture of the bridge mount stand 230 may be adjusted. In an embodiment, for example, the position of the bridge mount stand magnet 233 may be adjusted in response to the fourth signal S4. In an embodiment, for example, the current applied to the bridge mount stand magnet 233 may be adjusted in response to the fourth signal S4.

The control unit 330 may transmit the fifth signal S5 to the welding unit 350. The fifth signal S5 may include instruction information on the operation of the welding unit 350. The welding unit 350 may operate in response to the fifth signal S5. In an embodiment, for example, the welding unit 350 may operate in response to the fifth signal S5, and thus a laser beam may be radiated to the mask stick 20.

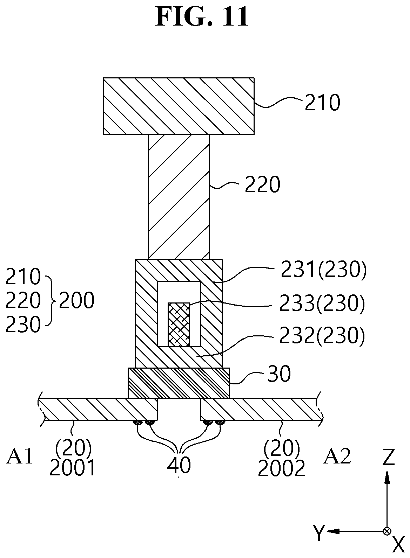

FIG. 11 illustrates a part of FIG. 7 in which a bridge mount is positioned above a mask mount, and a mask stick and a bridge stick are welded in a state of being fixed to the bridge mount.

Referring to FIGS. 7 and 11, in an embodiment, the bridge mount 200 may be positioned above the mask mount 100. In an embodiment, for example, the bridge mount 200 may be positioned above the mask mount stand 130.

The bridge mount leg 220 may form a shape extending downward from the bridge mount base 210. In an embodiment, for example, the upper end of the bridge mount leg 220 may be coupled to the bridge mount base 210, and the lower end of the bridge mount leg 220 may be coupled to the bridge mount stand 230.

The bridge mount stand 230 may include the bridge mount stand top 232 coupled to the bridge mount leg 220. The bridge stick 30 may be attached to the lower surface of the bridge mount stand top 232. In this context, the bridge mount stand top 232 may be referred to as a "bridge mount stand attachment portion".

The bridge mount stand magnet 233 may be positioned on the bridge mount stand top 232. The bridge mount stand magnet 233 may move toward or away from the bridge mount stand top 232.

The bridge mount 200 and the mask mount 100 may be positioned on opposite sides with respect to the mask stick 20. This can reduce spatial constraints in installing the bridge mount 200.

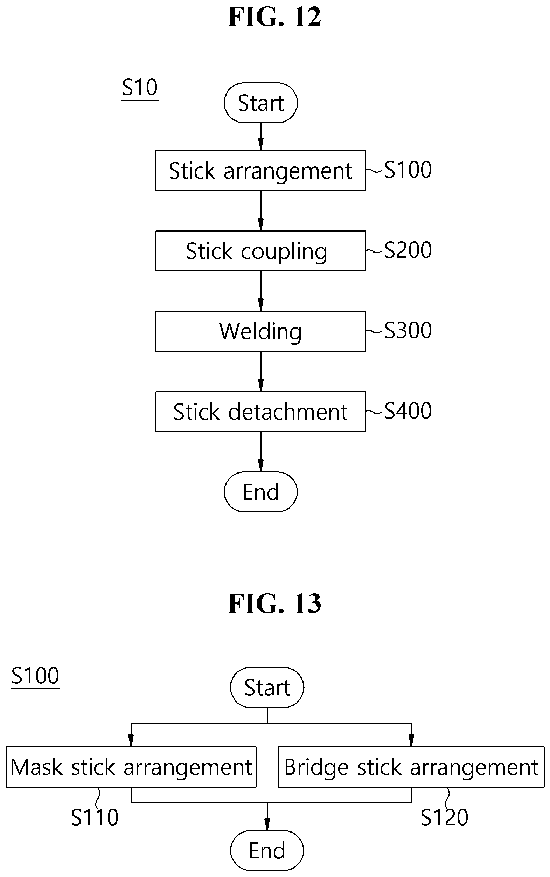

FIG. 12 is a flowchart illustrating a mask assembly method according to an embodiment of the disclosure.

Referring to FIGS. 1 to 12, a mask assembly method (or a method of assembling a mask) S10 may include a stick arrangement process S100. Sticks 20 and 30 may include or indicate at least one selected from the mask stick 20 and the bridge stick 30.

In the process S100, the mask stick 20 may be disposed on the mask mount stand 130. In the process S100, the bridge stick 30 may be disposed on the bridge mount 200.

In an embodiment, for example, in the process S100, the bridge stick 30 may be adsorbed on the bridge mount stand top 232. In an embodiment, for example, in the process S100, the bridge sticks 30 may be aligned.

In the process S100, a clamp (not shown) coupled to the mask mount base 110 may fix the mask stick 20 to the mask mount stand 130.

In an embodiment, for example, in the process S100, a Coulomb force may act between the mask stick 20 and the mask mount stand electrode 133. In an embodiment, for example, in the process S100, the mask stick 20 may be in close contact with the mask mount stand top 132. In an embodiment, for example, in the process S100, the mask stick 20 may be aligned.

The mask assembly method S10 may further include a stick coupling process S200. In the process S200, the mask stick 20 and the bridge stick 30 may be coupled to each other. In an embodiment, for example, in the process S200, the mask stick 20 and the bridge stick 30 may be magnetically coupled to each other.

In an embodiment, for example, in the process S200, the bridge stick 30 may be in close contact with the bridge mount stand top 232. In an embodiment, for example, in the process S200, the bridge stick 30 may maintain a state of being adsorbed on the bridge mount stand top 232. In an embodiment, for example, in the process S200, the bridge stick 30 may be magnetically coupled to the bridge mount stand magnet 233.

The mask assembly method S10 may include a welding process S300. In the process S300, the mask stick 20 and the bridge stick 30 may be welded and coupled to each other. In an embodiment, for example, in the process S300, the mask stick 20 may be irradiated with a laser beam.

In an embodiment, for example, in the process S300, the laser beam may be radiated to an area where the mask stick 20 and the bridge stick 30 overlap each other. In an embodiment, for example, in the process S300, weld beads 40 may be formed in the mask stick 20.

The mask assembly method S10 may include a stick detachment process S400. In the process S400, the coupling between the bridge stick 30 and the bridge mount 200 may be released. In the process S400, the bridge mount stand 230 may return to the original or initial position. In an embodiment, for example, in the process S400, the bridge mount stand 230 may approach the bridge mount base 210.

In the process S400, the coupling between the mask stick 20 and the mask mount 100 may be released. In the process S400, a coupling between the clamp (not shown) and the mask stick 20 may be released.

FIG. 13 is a flowchart illustrating a stick arrangement process.

Referring to FIGS. 1 to 13, the stick arrangement process S100 may include a mask stick arrangement process S110. In the process S110, the mask stick 20 may be mounted on the mask mount stand 130.

In the process S110, a position of the mask stick 20 with respect to the mask mount base 110 may be adjusted. In an embodiment, for example, the control unit 330 may control the mask mount leg 120 based on the second signal S2.

The stick arrangement process S100 may further include a bridge stick arrangement process S120. In the process S120, the bridge stick 30 may be mounted on the bridge mount stand 230.

In the process S120, a position of the bridge stick 30 with respect to the bridge mount base 210 may be adjusted. In an embodiment, for example, the control unit 330 may control the bridge mount leg 220 based on the second signal S2.

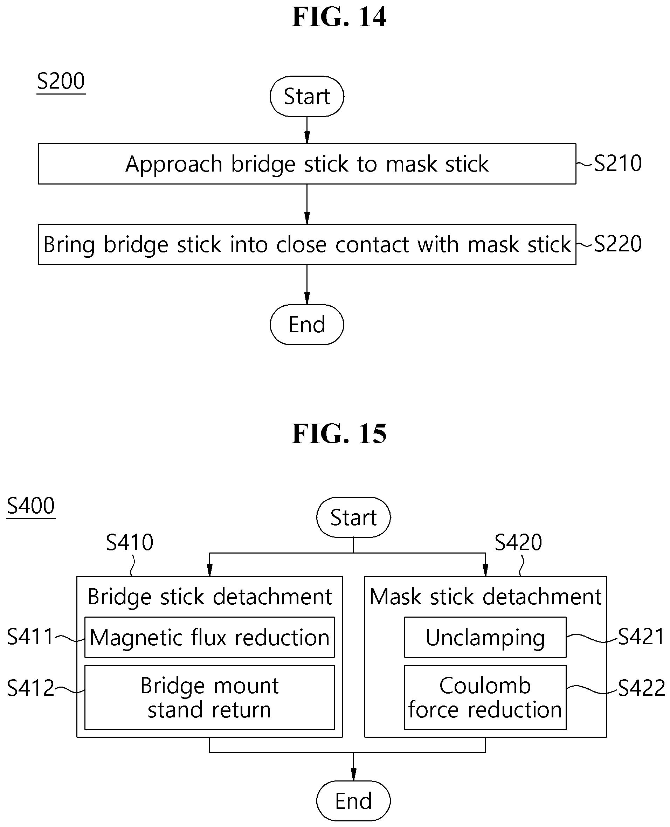

FIG. 14 is a flowchart illustrating a stick coupling process.

Referring to FIGS. 1 to 14, the stick coupling process S200 may include a process S210 in which the bridge stick 30 approaches the mask stick 20. In the process S210, referring to FIG. 8, as the bridge mount stand 230 moves up, the bridge stick 30 may approach the mask stick 20. In the process S210, referring to FIG. 11, as the bridge mount stand 230 moves down, the bridge stick 30 may approach the mask stick 20.

The stick coupling process S200 may include a process S220 in which the bridge stick 30 is in close contact with the mask stick 20. In the process S220, the bridge stick 30 and the mask stick 20 may be magnetically coupled to each other.

In an embodiment, for example, in the process S220, an intensity of a magnetic flux applied to the bridge stick 30 and the mask stick 20 may increase. In an embodiment, for example, in the process S220, the bridge mount stand magnet 233 may approach the bridge stick 30. In an embodiment, for example, in the process S220, a magnitude of a current applied to the bridge mount stand magnet 233 may increase.

In an embodiment, for example, in the process S220, a magnetic coupling between the bridge stick 30 and the bridge mount stand magnet 233 may be generated or increased. In an embodiment, for example, in the process S220, a magnetic coupling between the mask stick 20 and the bridge mount stand magnet 233 may be generated or increased.

In the process S220, a pressure that the bridge stick 30 applies to the mask stick 20 may increase. In an embodiment, for example, in the process S220, a pressure that the mask stick 20 receives from the bridge stick 30 and the bridge mount 200 may increase. In an embodiment, for example, in the process S220, the bridge stick 30 and the mask stick 20 may be in close contact with each other.

FIG. 15 is a flowchart illustrating a stick detachment process.

Referring to FIGS. 1 to 15, the stick detachment process S400 may include a bridge stick detachment process S410.

The bridge stick detachment process S410 may include a process S411 of reducing the magnetic flux applied to the bridge stick 30. In the process S411, the magnetic flux applied to the bridge stick 30 may be reduced or removed.

In the process S411, a magnetic coupling force between the bridge stick 30 and the bridge mount stand magnet 233 may be reduced or removed. In the process S411, a magnetic coupling force between the mask stick 20 and the bridge mount stand magnet 233 may be reduced or removed.

In an embodiment, for example, in the process S411, the bridge mount stand magnet 233 may go away from the bridge stick 30. In an embodiment, for example, in the process S411, an intensity of the current applied to the bridge mount stand magnet 233 may be reduced or removed. In an embodiment, for example, in the process S411, a direction of the current applied to the bridge mount stand magnet 233 may be reversed.

The bridge stick detachment process S410 may include a process S412 in which the bridge mount stand 230 returns. In the process S412, the bridge mount stand 230 may go away from the bridge stick 30. In the process S412, the control unit 330 may control the bridge mount leg 220 to separate the bridge stick 30 from the bridge mount stand 230.

In an embodiment, for example, the magnetic flux reduction process S411 may be performed before the bridge mount stand return process S412. In another embodiment, for example, the magnetic flux reduction process S411 may be performed at the same time as the bridge mount stand return process S412.

The stick detachment process S400 may further include a mask stick detachment process S420. The mask stick detachment process S420 may include an unclamping process S421. In the process S421, the coupling between the clamp (not shown) and the mask stick 20 may be released.

The mask stick detachment process S420 may include a Coulomb force reduction process S422. In the process S422, an electric potential difference applied to the mask mount stand electrode 133 and the mask stick 20 may be reduced or reversed.

In the process S420, the coupling between the mask mount stand electrode 133 and the mask stick 20 may be released. In an embodiment, for example, in the process S420, a coupling force between the mask mount stand electrode 133 and the mask stick 20 may be reduced. In an embodiment, for example, in the process S420, Coulomb force formed between the mask mount stand electrode 133 and the mask stick 20 may be reduced.

In an embodiment, for example, the unclamping process S421 may be performed before the Coulomb force reduction process S422. In another embodiment, for example, the Coulomb force reduction process S422 may be performed before the unclamping process S421. In another embodiment, for example, the Coulomb force reduction process S422 and the unclamping process S421 may be performed at the same time.

Referring to FIGS. 1 to 15, an embodiment of a mask may include a plurality of mask sticks 20, at least one bridge stick 30, and weld beads 40.

In an embodiment, for example, the mask may include the front mask stick 2001 and the rear mask stick 2002. In an embodiment, for example, the mask may include the bridge stick 30 that connects the front mask stick 2001 to the rear mask stick 2002. In an embodiment, for example, the mask may include the weld beads 40 formed in the mask stick 20.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A mask assembly device (10) comprising:
a front mask mount (101) and a rear mask mount (102), wherein each of the front mask mount (101) and the rear mask mount (102) includes a mask mount stand (130); and
a bridge mount (200) including a bridge mount stand (230),
wherein the bridge mount stand (230) includes:
a bridge mount stand top (232) positioned between the front mask mount (101) and the rear mask mount (102); and
a bridge mount stand magnet (233) configured to provide a magnetic flux to the bridge mount stand top (232).

2. The mask assembly device (10) of claim 1, wherein an upper surface of the bridge mount (200) is positioned below an upper surface of the front mask mount (101) and an upper surface of the rear mask mount (102), and
wherein the bridge mount stand magnet (233) is positioned below the bridge mount stand top (232).

3. The mask assembly device (10) of claim 2, wherein the bridge mount stand (230) further includes a bridge mount stand body (231) coupled to the bridge mount stand top (232), and
wherein the bridge mount stand magnet (233) is movably coupled to the bridge mount stand body (231) in a way such that the bridge mount stand magnet (233) is configured to be movable toward or away from the bridge mount stand top (232).

4. The mask assembly device (10) of claim 2 or claim 3, wherein the bridge mount stand magnet (233) is configured to form a magnetic field corresponding to a current applied to the bridge mount stand magnet (233).

5. The mask assembly device (10) of any preceding claim, wherein the bridge mount stand (230) further includes:
a bridge mount base (210); and
a bridge mount leg (220) connecting the bridge mount base (210) to the bridge mount stand (230);
optionally wherein the bridge mount stand (230) is coupled to the bridge mount leg (220) in a way such that the bridge mount stand (230) is configured to be movable up and down with respect to the bridge mount base (210).

6. The mask assembly device (10) of any preceding claim, wherein a suction hole is defined on an upper surface of the bridge mount stand top (232).

7. The mask assembly device (10) of any preceding claim, wherein the mask mount stand (130) includes:
a mask mount stand body (131);
a mask mount stand top (132) defining an upper surface of a corresponding one of the front mask mount (101) and the rear mask mount (102); and
a mask mount stand electrode (133) positioned below the mask mount stand top (132) and positioned in the mask mount stand body (131);
optionally wherein the mask mount stand top (132) includes a material including a dielectric.

8. A mask assembly method comprising:
arranging a mask stick (20) on an upper surface of a mask mount stand (130) and arranging a bridge stick (30) on an upper surface of a bridge mount stand (230), wherein the mask stick (20) is positioned above the bridge stick (30);
coupling the mask stick (20) to the bridge stick (30); and
welding an area in which the mask stick (20) and the bridge stick (30) overlap each other.

9. The mask assembly method (S10) of claim 8, wherein the coupling the mask stick (20) to the bridge stick (30) comprises:
moving the bridge mount stand (230) up to allow the bridge stick (30) to approach the mask stick (20); and
bringing the bridge stick (30) into close contact with the mask stick (20).

10. The mask assembly method of claim 9, wherein the bridge mount stand (230) includes:
a bridge mount stand body (231);
a bridge mount stand top (232) connected to the bridge mount stand body (231), wherein the bridge stick (30) is seated on an upper surface of the bridge mount stand top (232); and
a bridge mount stand magnet (233) positioned below the bridge mount stand top (232), wherein the bridge mount stand magnet (233) is configured to provide a magnetic flux to the bridge mount stand top (232).

11. The mask assembly method of claim 10, (i) wherein the bridge mount stand magnet (233) is movably coupled to at least one selected from the bridge mount stand body (231) and the bridge mount stand top (232), and
wherein when the bridge mount stand magnet (233) approaches the bridge mount stand top (232), the bridge stick (30) is in close contact with the mask stick (20); and/or
(ii) wherein the bridge mount stand magnet (233) includes an electromagnet, and
wherein when a magnitude of a current applied to the bridge mount stand magnet (233) increases, the bridge stick (30) is in close contact with the mask stick (20).

12. The mask assembly method of claim 10 or claim 11, (i) further comprising, after the welding:
reducing an intensity of the magnetic flux provided by the bridge mount stand magnet (233) to the bridge mount stand top (232); and
moving the bridge mount stand (230) down; and/or
(ii) wherein a suction hole is defined on the bridge mount stand top (232), and
wherein the arranging the bridge stick (30) on the upper surface of the bridge mount stand (230) and coupling the mask stick (20) to the bridge stick (30) comprises adsorbing the bridge stick (30) on the bridge mount stand top (232) through the suction hole.

13. The mask assembly method of any of claims 8 to 12, wherein the arranging the mask stick (20) on the upper surface of the mask mount stand (130) comprises capacitively coupling the mask stick (20) to the mask mount stand (130).

14. A mask comprising:
a mask stick (20) including:
a front mask stick (2001) extending in a left-right direction; and
a rear mask stick (2002) extending in the left-right direction and disposed behind the front mask stick (2001) to be spaced apart from the front mask stick (2001); and
a bridge stick (30) connecting the front mask stick (2001) to the rear mask stick (2002), wherein the bridge stick (30) is positioned below the front mask stick (2001) and the rear mask stick (2002),
wherein the bridge stick (30) extends in the left-right direction, and
wherein an upper surface of the bridge stick (30) is in contact with a lower surface of the mask stick (20) and coupled to the mask stick (20) by welding.

15. The mask of claim 14, further comprising a weld bead (40) positioned on at least one selected from the mask stick (20) and the bridge stick (30);
optionally wherein the weld bead (40) is positioned in an area of an upper surface of the mask stick (20), in which the mask stick (20) and the bridge stick (30) overlap each other.
